# EUROPÄISCHE PATENTSCHRIFT

(11) **EP 1 564 754 B1**
(45) Veröffentlichungstag und Bekanntmachung des Hinweises auf die Patenterteilung: **29.07.2009**
(21) Anmeldenummer: 04030429.7
(22) Anmeldetag: 22.12.2004
(51) Int. Cl.: G11C 16/16, G11C 16/34

(54) **Verfahren und Vorrichtung zur Verwaltung von Daten in einem nichtflüchtigen Datenspeicher**
Method and device for managing data in a non-volatile memory
Procédé et dispositif pour gérer des données dans une mémoire non-volatile

(30) Priorität: 03.02.2004 DE 102004005290
(43) Veröffentlichungstag der Anmeldung: 17.08.2005
(73) Patentinhaber: Giesecke & Devrient GmbH, 81677 München (DE)
(72) Erfinder: Wallhäusser, Curd, 80995 München (DE)
(74) Vertreter: Klunker . Schmitt-Nilson . Hirsch

(56) Entgegenhaltungen:
- WO-A-03/010671
- US-A- 5 437 012
- US-A1- 2002 099 904
- US-A1- 2003 189 860
- PATENT ABSTRACTS OF JAPAN Bd. 2003, Nr. 02, 5. Februar 2003 (2003-02-05) & JP 2002 318733 A (MATSUSHITA ELECTRIC WORKS LTD), 31. Oktober 2002 (2002-10-31)
- PATENT ABSTRACTS OF JAPAN Bd. 2003, Nr. 09, 3. September 2003 (2003-09-03) & JP 2003 157204 A (CANON INC), 30. Mai 2003 (2003-05-30)

## Beschreibung

Die Erfindung betrifft die Verwaltung von Daten eines nichtflüchtigen und in Speichersegmente unterteilten Datenspeichers sowie insbesondere die Absicherung von Transaktionen, die zumindest eine Schreiboperation in einem der Speichersegmente auslösen.

In nahezu jedem System gibt es Daten, auf deren Vorliegen in einem nichtflüchtigen Speicher und auf deren Richtigkeit sich das System verlassen können muß. Derartige Daten sollten also immer in einem definierten Zustand gehalten werden.

Kompakte Einheiten wie beispielsweise Chipkarten, USB-Token oder andere mobile Datenträger haben selten eine interne Stromversorgung. Es besteht dadurch das Risiko, daß während eines Schreibvorganges die externe Stromversorgung unterbrochen wird. Der Wert des beschriebenen Datenfeldes kann dann nicht mehr als definiert angesehen werden. Er kann in einem unveränderten, bereits geänderten oder nur unvollständig geänderten Zustand sein.

Um Daten in einem Datenspeicher immer in einem definierten Zustand zu halten, werden Schreiboperationen als sogenannte atomare Schreiboperationen ausgeführt. Für eine atomare Schreiboperation wird sichergestellt, daß entweder neue Daten vollständig geschrieben werden oder die entsprechenden alten Daten erhalten bleiben. Nach einem Abbruch einer Schreiboperation wird das betroffene Datenfeld beispielsweise auf den Zustand vor der Schreiboperation zurückgeführt.

Es ist bekannt, zu diesem Zweck einen Rückführpuffer zu verwenden, in welchen zunächst die alten Daten aus dem Datenspeicher gesichert werden. Anschließend werden die alten Daten im Datenspeicher überschrieben. Eine Statusinformation zeigt an, ob der Rückführpuffer alte Daten enthält. Nach einer Unterbrechung und Wiederherstellung der Stromversorgung kann anhand der Statusinformation entschieden werden, ob alte Daten in den Datenspeicher zurück zu führen sind.

Bei einigen Arten von Datenspeichern, beispielsweise Flash-EEPROM, können Bits zwar einzeln auf einen einzigen Binärwert - z. B. den Wert "0" - gesetzt werden, aber nur jeweils alle Bits einer ganzen Speicherseite auf den anderen Binärwert - z. B. den Wert "1" - gelöscht werden. Das Löschen einer Speicherseite ist im Vergleich zu dem Beschreiben der Speicherseite der zeitlich aufwendigere Schritt. Ein Verfahren, das einen Rückführpuffer verwendet, muß aber sowohl die Speicherseite des Rückführpuffers als auch die Speicherseite der alten Daten löschen und ist daher zeitaufwendig.

Für Flash-Speicher offenbart die Druckschrift US 5,832,493 A ein Verfahren, in welchem die Sektoren eines Speichers über zugewiesene Adressen verwaltet werden. Alte Daten in einem ersten Sektor sind mit einer zugewiesenen Adresse adressierbar. Sie können nun durch neue Daten in einem zweiten Sektor ersetzt werden, welche die gleiche zugewiesene Adresse aufweisen. Somit ist für einen atomaren Schreibvorgang nur eine Speicherseite, nämlich die der alten Daten, zu löschen. In einem entsprechenden Verfahren werden die alten Daten des ersten Sektors zunächst als "zu überschreiben" (prediscarded) gekennzeichnet. Nach dem Schreiben der neuen Daten in den neuen Sektor werden die alten Daten in dem alten Sektor dann als "zu löschen" (discarded) gekennzeichnet.

WO 03/01067 A1 worauf der Oberbegriff der unabhängigen Ansprüche beruht, zeigt ein Verfahren zur Absicherung von Speichersegmenten, in welchen vor und nach dem Löschen eines alten Speichersegmentes der Status des neuen Speichersegmentes geändert wird. Ein Verweis auf das alte Speichersegment ist in dem neuen Speichersegment enthalten, um das alte Speichersegment für einen - gegebenenfalls nach einem unvollständigen Löschen nötigen - erneuten Löschvorgang identifizieren zu können.

In US 5 437 012 A1 wird ein virtuelles Abbild des Speichers einer optischen Speicherkarte auf einem PC erzeugt und für ein Schreiben geänderter Daten auf die Speicherkarte verwendet. Um nach Stromausfall Daten restaurieren zu können, werden Verwaltungs- daten, die ltersrangdaten, wie z. B. "revision numbers", mit eingeschrieben.

Es ist die Aufgabe der vorliegenden Erfindung ein Verfahren und eine Vorrichtung zur Absicherung von Daten in einem nichtflüchtigen und in Speichersegmente unterteilten Datenspeicher bereitzustellen, welche erhöhten Anforderungen an eine Datensicherheit genügen.

Diese Aufgabe wird gelöst durch ein Verfahren bzw. eine Vorrichtung gemäß den unabhängigen Ansprüchen. Die abhängigen Ansprüche definieren bevorzugte Ausgestaltungen der Erfindung.

Die vorliegende Erfindung geht von dem Ansatz aus, für ein Speichersegment neben einem Status ein weiteres Datenelement vorzusehen. Für den Fall, daß ein Löschen des Speichersegments nicht vollständig ausgeführt wurde, ermöglicht das weitere Datenelement die Bestimmung des Altersranges der Daten in dem nicht vollständig gelöschten Speichersegment gegenüber Daten in einem zweiten Speichersegment. Das Verwenden eines weiteren Datenelementes widerspricht dem üblichen Ansatz, die Anzahl der Datenelemente zur Verwaltung von Nutzdaten zu minimieren. Die Absicherung eines atomaren Schreibvorgangs wird dadurch jedoch verbessert.

Gemäß einer bevorzugten Ausgestaltung des Verfahrens umfaßt das Datenelement zur Bestimmung des relativen Altersranges einen Verweis auf das alte Speichersegment. Ein solcher Verweis in den Verwaltungsdaten des neuen Speichersegments ermöglicht die Zuordnung des neuen Speichersegments zu einem alten Speichersegment durch ein Datenelement mit einer vergleichsweise geringen Größe.

Gemäß einer weiteren Ausgestaltung des Verfahrens umfaßt das Datenelement zur Bestimmung des relativen Altersranges Altersrangdaten, die so gewählt sind, daß sie durch ein unvollständiges Löschen in einen Zustand übergehen, der als unvollständig gelöschter Zustand erkennbar ist. Dieses weitere Datenelement ermöglicht eine Erkennung des älteren Speichersegments auch in dem Fall, wenn beide Speichersegmente sich über ihre Verweise gegenseitig als jeweils Älteres angeben.

In einer besonders vorteilhaften Ausgestaltung können die Altersrangdaten drei Zustände kodieren, um unabhängig von einem Wert der Altersrangdaten eines alten Speichersegments das neue Speichersegment mit einem Wert versehen zu können, der als jünger eingestuft wird.

Es ist weiterhin vorteilhaft, die Altersrangdaten so auszubilden, daß sie sich in nur einem Bit von einem gelöschten Zustand eines Datenelementes in dem Datenspeicher unterscheiden. Durch diese Ausgestaltung wird erreicht, daß die Altersrangdaten selbst bei einem nicht vollständigen Löschen des entsprechenden Speichersegmentes entweder in ihrem ursprünglichen Zustand verbleiben oder auf einen insgesamt gelöschten Zustand gesetzt werden.

Gemäß einer bevorzugten Ausgestaltung dient das Verfahren zur Absicherung eines Vorgangs mit einer Vielzahl in verschiedenen Speichersegmenten zu ersetzender Daten. Es umfaßt ein Schreiben von neuen Daten, ein erstes Ändern des Statusdatenelements sowie einen Schritt enthaltend ein Löschen der alten Daten und ein zweites Ändern des Statusdatenelements. Jeder dieser Schritte wird jeweils für alle zu ersetzenden Daten ausgeführt, bevor mit dem nächsten Schritt fortgefahren wird.

Gemäß einem weiteren Aspekt der vorliegenden Erfindung enthält ein Speichersegment eines nichtflüchtigen Datenspeichers jeweils einen Bereich für Verwaltungsdaten und einen Bereich für Nutzdaten, wobei die Verwaltungsdaten Statusdaten zur Kennzeichnung eines Zustandes des jeweiligen Speichersegments enthalten. Mittel zur Aktivierung des jeweiligen Speichersegments, die das Speichersegment aktivieren, wenn es über ein entsprechendes Adress-Signal angesprochen wird, werten die Adresse des Speichersegmentes und die Statusdaten des Speichersegmentes aus, um zu bestimmen, ob das Speichersegment aktiviert wird. Eine derartige Beschaltung eines Datenspeichers verbessert die Zugriffszeiten auf die entsprechenden Daten.

Gemäß einer bevorzugten Ausführungsform umfassen die Verwaltungsdaten eine zugewiesene Adresse des Speichersegmentes, die von den Aktivierungsmitteln ausgewertet wird. Somit kann zusätzlicher Verwaltungsaufwand für zugewiesene Adressen vermieden werden.

Gemäß einer weiteren bevorzugten Ausführungsform sind die Mittel zur Aktivierung des Speichersegments angepaßt, wahlweise eine Adressierung über eine physikalische oder eine zugewiesene Adresse des Speichersegments vorzunehmen. Einem Vergleichselement wird abhängig von einem Adress-Signal entweder die physikalische Adresse oder die zugewiesene Adresse des Speichersegments zugeführt. Ein Verknüpfungselement verknüpft das Adress-Signal und das Ergebnis einer Auswertung der Statusdaten. Durch eine solche Struktur kann der Datenspeicher bei einer Adressierung über die physikalische Adresse transparent betrieben werden.

Weitere Merkmale und Vorteile der Erfindung ergeben sich aus der folgenden Beschreibung von Ausführungsbeispielen gemäß der Erfindung. Die Ausführungsbeispiele werden anhand der Figuren beschrieben, welche im einzelnen zeigen:
- Fig.1: eine schematische Darstellung einer Datenstruktur in einem Datenspeicher;
- Fig. 2: ein Ablaufdiagramm für ein Verfahren zur Absicherung eines Schreibvorganges;
- Fig. 3: eine schematische Darstellung der Speicherinhalte zweier Speichersegmente in der Folge der Änderungen durch ein Verfahren gemäß Fig. 2;
- Fig. 4: ein Ablaufdiagramm für ein Verfahren zur Rückführung von Speicherinhalten abhängig von Verwaltungsdaten in den Speichersegmenten;
- Fig. 5: eine schematische Darstellung eines mobilen Datenträgers;
- Fig. 6: eine schematische Darstellung eines Datenspeichers;
- Fig. 7: ein Ablaufdiagramm für ein Verfahren zur Absicherung einer komplexen Transaktion (unter Bezugnahme auf Fig. 2); und
- Fig. 8: ein Ablaufdiagramm für ein Verfahren zur Rückführung eines Datenspeichers nach einer komplexen Transaktion gemäß Fig. 7.

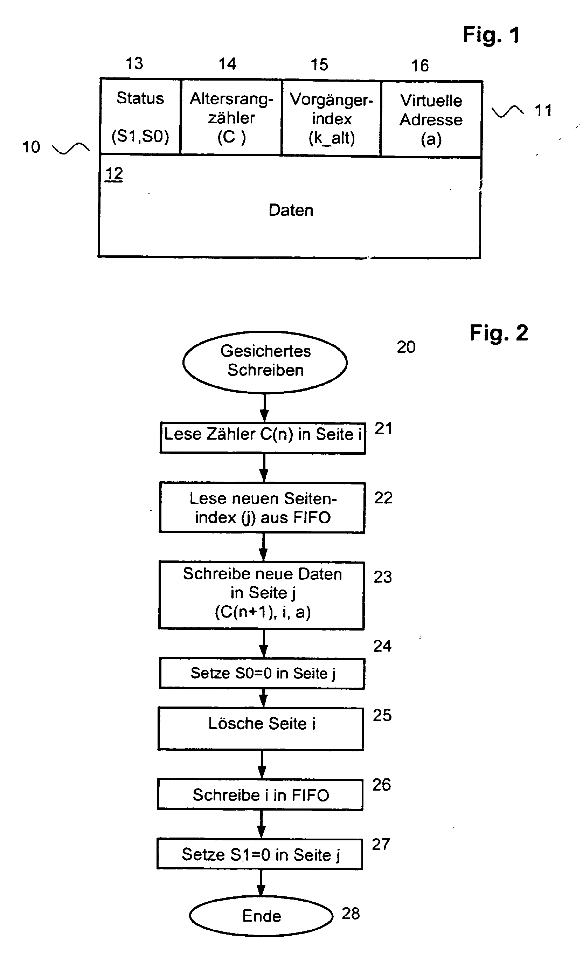

In Fig. 1 sind schematisch die Datenelemente einer Datenstruktur dargestellt, wie sie für die Vorgehensweise gemäß der vorliegenden Erfindung in nichtflüchtigen Datenspeichern verwendet wird.

Die Datenstruktur 10 enthält Verwaltungsdaten 11 sowie Nutzdaten 12. In den Verwaltungsdaten 11 sind ein Statusdatenelement 13, ein Altersrangzähler 14, ein Vorgängerindex 15 sowie eine virtuelle Adresse 16 enthalten.

Durch die Verwendung virtueller Adressen kann ein Speichersegment unabhängig von seiner physikalischen Adresse referenziert werden. Der Vorgängerindex 15 enthält einen Verweis auf das Speichersegment, welches zuvor mit der virtuellen Adresse 16 versehen war. Als Verweis kann beispielsweise die physikalische Adresse des alten Speichersegments verwendet werden.

Der notwendige Speicherplatz für die Datenelemente 15,16 bzw. deren Größe in Bits oder Bytes ist abhängig von der Anzahl der verwendeten physikalischen Adressen der Speichersegmente. Diese Anzahl kann dadurch begrenzt werden, daß nicht alle Speichersegmente eines Datenspeichers für eine virtuelle Adressierung und/oder atomare Schreiboperationen zur Verfügung gestellt werden.

Der Altersrangzähler 14 wird durch drei Bit kodiert. Jeweils nur ein Bit des Altersrangzählers 14 weicht von dem gelöschten Zustand der Datenelemente in dem Datenspeicher ab. Für die beschriebenen Ausführungsformen wird von einer Flash-Speicherseite ausgegangen, die ein schnelles Schreiben von einem Wert 1 auf einen Wert 0 ermöglicht und ein dagegen langsameres Löschen vom Wert 0 auf den Wert 1 benötigt.

Zwischen den drei möglichen Werten des Altersrangzählers (1,1,0); (1,0,1) und (0,1,1) wird ein Altersrang der Werte so definiert, daß jeweils ein Wert als älter als ein entsprechender Vergleichswert anzusehen ist. Die Altersrangfolge kann beispielsweise wie folgt definiert werden: (1,1,0) ist älter als (1,0,1), (1,0,1) ist älter als (0,1,1) und (0,1,1) ist älter als (1,1,0).

Das Statusdatenelement 13 wird durch zwei Bits S1 und S0 kodiert. Als Werte für einen Status werden in den nachfolgenden Figuren verwendet: (1,1) für ein gelöschtes Speichersegment, (1,0) für ein beschriebenes Speichersegment, dessen atomarer Schreibvorgang noch nicht abgeschlossen ist, und (0,0) für ein Speichersegment nach abgeschlossenem atomarem Schreibvorgang.

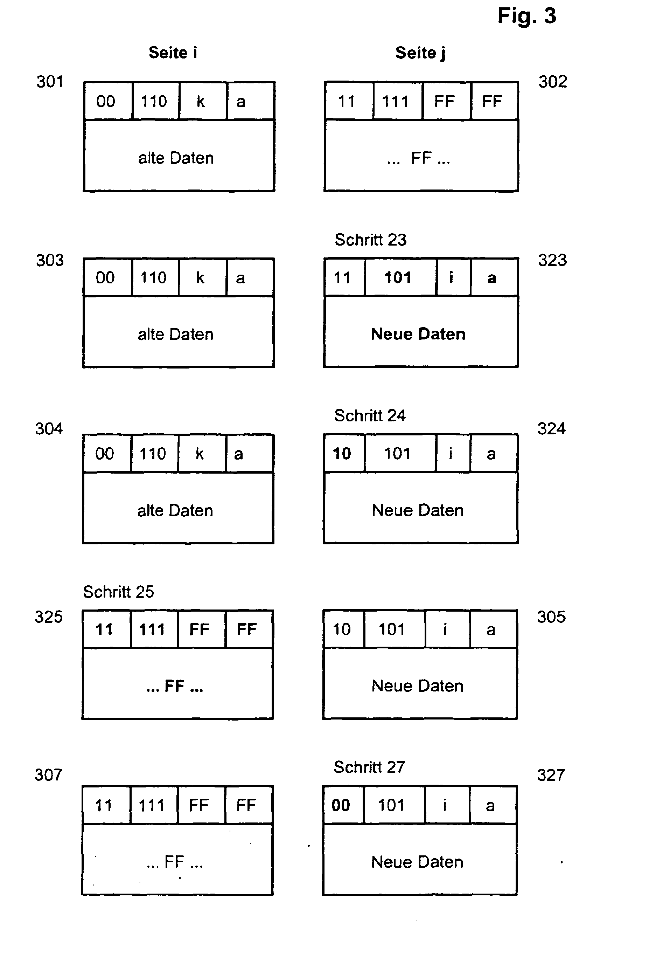

Ein Verfahren für ein gesichertes Schreiben von Daten in ein Speichersegment mit Schritten 20 bis 28 wird anhand von Fig. 2 beschrieben. Die Änderungen von Werten innerhalb der Datenstrukturen der beiden beteiligten Speicherseiten i und j durch einen solchen Verfahrensablauf ist dargestellt in Fig. 3.

In ihrem Ausgangszustand 301 enthält die Speicherseite i ein Statusdatenelement mit dem Wert (0,0). Die Speicherseite i enthält also die aktuell gültigen Daten, die über die virtuelle Adresse a adressierbar sind. Die Daten der Speicherseite j sind im Ausgangszustand 302 gelöscht, so daß sämtliche Bits der Speicherseite den Wert 1 haben.

Die alten Daten in der Speicherseite i sollen durch neue Daten ersetzt werden. Wie in Fig. 2 dargestellt, wird zunächst der Zähler C (n) der Speicherseite i ausgelesen in einem Schritt 21. Aus einem Ringpuffer, der noch genauer beschrieben wird, wird in einem Schritt 22 ein Seitenindex j der nächsten zu verwendenden Speicherseite ausgelesen.

Ausgehend von dem Altersrangzähler C(n) der alten Speicherseite i mit dem Wert (1,1,0) wird der nächstältere Wert gemäß der vorab festgelegten Rangfolge bestimmt. Der Wert des Altersrangzählers C(n+1) der neuen Speicherseite, der diese als die ältere der beiden beteiligten Speicherseiten kennzeichnet, ist in diesem Fall (1,0,1). In einem Schritt 23 werden die neuen Daten in die Speicherseite j geschrieben.

Wie in Fig. 3 erkennbar, bleiben die alten Daten der Speicherseite i im Zustand 303 unverändert. Die neuen Daten der Speicherseite j enthalten im Zustand 323 in den Verwaltungsdaten ein Statusdatenelement mit dem Wert (1,1) und den Altersrangzähler mit dem Wert (1,0,1). Der Vorgängerindex in den Verwaltungsdaten im Zustand 323 verweist auf die Speicherseite i. Die virtuelle Adresse der Speicherseite j ist der virtuellen Adresse der Vorgängerspeicherseite i gleichgesetzt, hat also ebenfalls den Wert a.

In einem Schritt 24 des Verfahrens gemäß Fig. 2 wird das Statusbit S0 der Speicherseite j auf Null gesetzt. Neben den weiterhin unveränderten Werten der Speicherseite i im Zustand 304 ist diese Änderung im Statusdatenelement der Speicherseite j im Zustand 324 erkennbar. In einem Schritt 25 erfolgt das Löschen der Speicherseite i. Im Zustand 325 der Speicherseite i sind alle Daten bereits gelöscht.

Der Seitenindex der gelöschten Speicherseite i wird in einem Schritt 26 in den Ringpuffer geschrieben. Um die Benutzung der Speicherseiten gleichmäßig auf alle verfügbaren Speicherseiten zu verteilen, speichert der Ringpuffer (FIFO) die Indizes der verfügbaren und gelöschten Speicherseiten. Die Indizes gerade gelöschter Seiten werden in den Ringpuffer geschoben und die Indizes einer für einen Schreibvorgang zu verwendenden Speicherseite an dem anderen Ende des Ringpuffers entnommen. Die Benutzung der Speicherseiten wird somit gleichmäßig auf alle Speicherseiten des Datenspeichers verteilt. Insbesondere bei Flash-Datenspeichern, die nur eine begrenzte Anzahl von Löschzyklen ermöglichen, kann dadurch die Gesamtlebensdauer des Datenspeichers erhöht werden.

In dem abschließenden Schritt 27 des Verfahrens gemäß Fig. 2 wird das Statusbit S1 der Speicherseite j auf Null gesetzt. Der Status der Speicherseite j zeigt im Zustand 327 an, daß die atomare Transaktion abgeschlossen und die Speicherseite j als aktuelle Speicherseite für die virtuelle Adresse a zu verwenden ist.

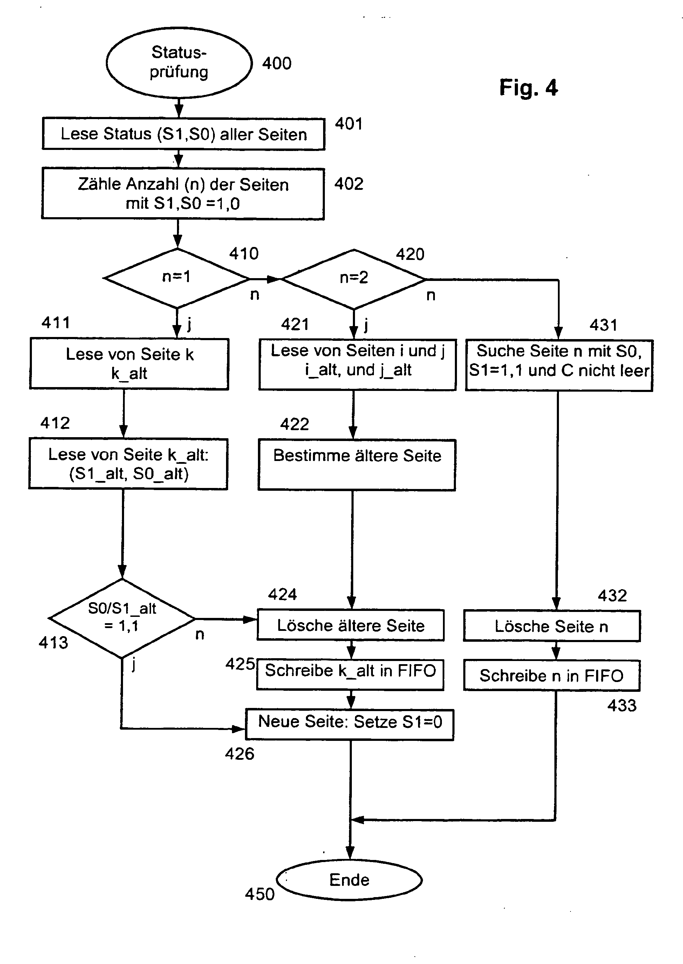

In Fig. 4 ist dargestellt ein Verfahren 400 bis 450 zur Statusprüfung bzw. zur Rückführung von Daten nach einer Stromunterbrechung, die während einer atomaren Transaktion nach dem Verfahren aus Fig. 2 aufgetreten ist. Ein solches Verfahren wird üblicherweise bei einem Neustart der Chipkarte nach einem Reset (erzwungener Neustart) oder einem Stromausfall durchgeführt, um sicherzustellen, daß die verwendeten Daten in einem konsistenten Zustand sind.

In einem ersten Schritt 401 werden die Verwaltungsdaten, insbesondere zumindest die Statusdaten, aller zu prüfender Speicherseiten ausgelesen. Eine Anzahl n der Seiten, für die das Statusdatenelement den Wert (1,0) hat, wird in einem Schritt 402 gezählt. Gemäß den Verzweigungen 410 und 420 wird das Verfahren abhängig von der ermittelten Anzahl n fortgesetzt.

Wurde ein atomarer Schreibvorgang nach Fig. 2 vor dem Schritt 24 des Setzen des Bit S0 auf den Wert 0 oder nach dem Schritt 27 des Setzen des Bit S1 auf den Wert 0 unterbrochen, so existiert keine Speicherseite mit dem Status (1,0). Falls eine Unterbrechung während dem Schritt 25 des Löschen der alten Speicherseite erfolgt, können zwei Speicherseiten mit dem Status (1,0) vorliegen, da ein zufälliger Übergang von dem Status (0,0) auf den Status (1,0) durch unvollständiges Löschen möglich ist. In allen anderen Fällen einer Unterbrechung des atomaren Schreibvorganges liegt genau eine Speicherseite mit dem Status (1,0) vor.

Wenn gemäß Verzweigung 410 die Anzahl n = 1 ist, wird von der entsprechenden Speicherseite k in einem Schritt 411 ein Verweis k_alt auf die Vorgängerseite gelesen. Aus der Vorgängerseite k_alt wird in Schritt 412 das Statusdatenelement der alten Seite ausgelesen. Zeigt das Statusdatenelement gemäß Verzweigung 413 an, daß die alte Speicherseite noch nicht gelöscht ist, wird die alte Speicherseite mit dem Index k_alt in einem Schritt 424 gelöscht und der Index k_alt in den Ringpuffer geschrieben (Schritt 425). Unabhängig von der Verzweigung 413 wird das Statusbit S1 der Seite k in einem Schritt 426 auf Null gesetzt.

Gibt es dagegen gemäß Verzweigung 420 zwei Speicherseiten mit dem Wert (1,0) im Statusdatenelement, werden beide Altersrangzähler Ci und Cj der Speicherseiten i und j in einem Schritt 421 gelesen. Anhand der gelesenen Altersrangzähler Ci und Cj wird in einem Schritt 422 bestimmt, welche der beiden Speicherseiten zuletzt beschrieben wurde. Ein Altersrangzähler kann sich dabei als der Ältere erweisen, wenn er einem gelöschten Zustand entspricht oder wenn er gemäß der vorab festgelegten Definition als der Ältere anzusehen ist. In dem Schritt 424 wird die ältere Speicherseite dann gelöscht. Der Seitenindex der gelöschten Speicherseite wird in dem Schritt 425 in den Ringpuffer geschrieben. Schließlich wird wiederum mit dem Schritt 426 das Statusbit S1 der neuen Speicherseite auf Null gesetzt.

Ergibt die Auswertung der Anzahl n durch die Verzweigungen 410 und 420, daß keine Speicherseite mit dem Wert (1,0) im Statusdatenelement festgestellt wird, so kann immer noch eine Unterbrechung direkt nach dem Schritt 23 aus Fig. 2 vorliegen. Daher wird in einem Schritt 431 geprüft, ob eine Speicherseite n existiert, die mit einem Status (1,1) und weiteren Verwaltungsdaten, welche nicht gelöscht sind, versehen ist. Eine solche Seite n wird in einem Schritt 432 gelöscht und der Seitenindex n in einem Schritt 433 in den Ringpuffer geschrieben.

Da die Verwaltungsdaten der Speicherseiten bereits in dem Schritt 401 zumindest teilweise ausgelesen werden, können die Schritte 431 bis 433 alternativ in dem Schritt des Auslesens 401 erfolgen.

Weiterhin ist anzumerken, daß die Schritte 431 bis 432 und 413 optionale Schritte des Verfahrens sind. Die Indizes der durch diese Schritte behandelten Speicherseiten sind nicht mehr oder noch nicht im Ringpuffer gespeichert und werden daher auch nicht weiter verwendet. Ein Aufräumen des Datenspeichers durch Auswerten und Behandeln dieser Speicherseiten kann daher unabhängig von der Rückführung von Daten nach atomaren Transaktionen erfolgen.

Das in Fig. 4 dargestellte Verfahren erlaubt alle Daten, die durch eine Unterbrechung während einer einfachen abgesicherten Transaktion beeinflußt werden könnten, schnell und sicher in einen definierten Zustand zurück zu führen.

Wenn es eine Unterbrechung gab, wird in der Regel eine Speicherseite mit einem Statusdatenelement (1,0) vorliegen, da der Schritt des Löschens 25 einer Speicherseite nach Fig. 2 relativ lange dauert. Dieser Fall kann über die Auswertung des Vorgängerverweises schnell behandelt werden (Schritte 411 bis 413).

Der seltenere Fall, daß zufällig eine zweite Speicherseite ebenfalls den Status (1,0) aufweist, wird dadurch kompliziert, daß theoretisch auch die Vorgängerverweise der beiden Speicherseiten zufällig aufeinander verweisen könnten. Der Altersrangzähler ermöglicht das eindeutige Identifizieren und entsprechende Löschen der älteren Speicherseite (Schritte 420 bis 426).

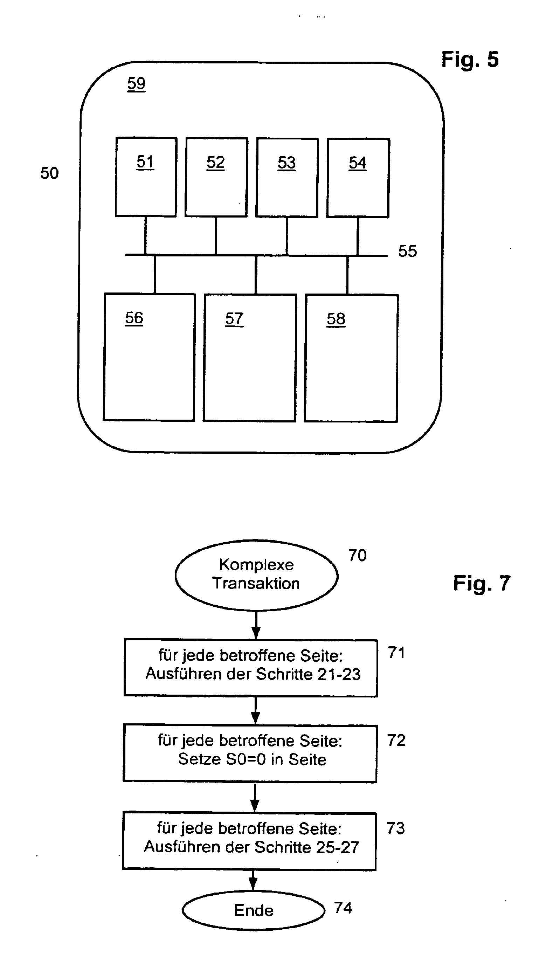

In Fig. 5 sind die grundlegenden funktionalen Elemente eines tragbaren Datenträgers 50 dargestellt. Als tragbarer Datenträger kann beispielsweise eine Chipkarte, ein USB-Token oder eine SIM-Karte für ein Endgerät eines Mobilfunksystem vorliegen.

Neben einer CPU 51 ist eine Schnittstelle 52 vorgesehen, die kontaktlos und/oder kontaktbehaftet eine Kommunikation zu externen Komponenten bzw. im mobilen Datenträger angeordneten weiteren Komponenten ermöglicht. Eine kryptografische Einheit 53 zur Ausführung kryptografischer Berechnungen sowie ein Detektor oder Sensor 54 zur Erkennung von äußeren Angriffen gegen den mobilen Datenträger sind ebenfalls vorhanden. Als Speicherelemente sind vorgesehen ein flüchtiger Speicher (RAM) 56, ein nicht mehrfach beschreibbarer Speicher (ROM) 57 und ein nichtflüchtiger und in Segmenten organisierter Speicher (Flash-EEPROM) 58. Die Elemente 51 bis 54 und 56 bis 58 sind zumindest über eine Leitung 55, vorzugsweise einen Bus, miteinander verbunden. Optional weist der mobile Datenträger eine eigene Stromversorgung auf.

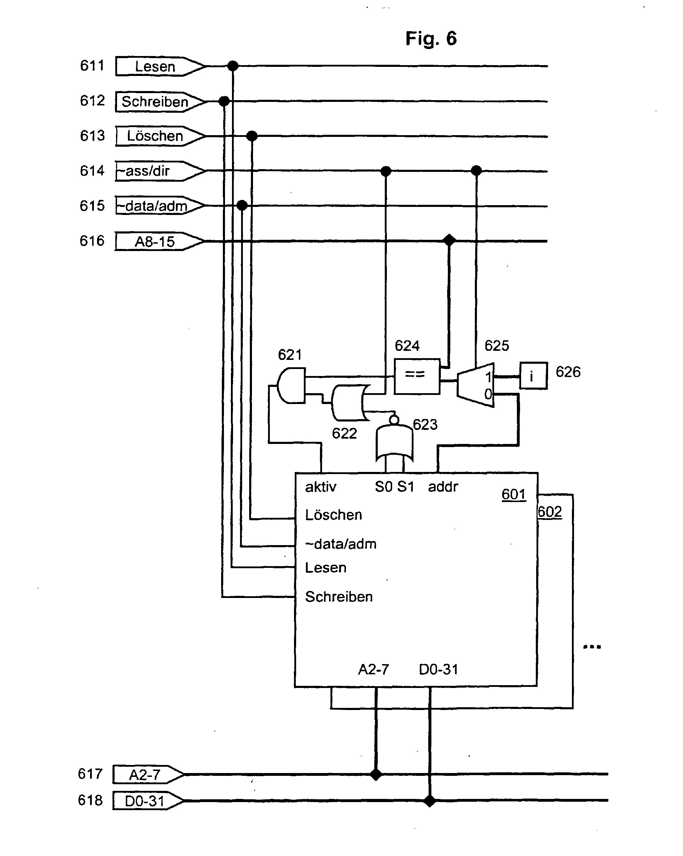

Die Speichersegmente des Datenspeichers 58 können, wie in Fig. 6 gezeigt, erfindungsgemäß angepaßt sein und/ oder, wie in den Fig. 2, 4, 7 oder 8 gezeigt verwendet werden. Eine Steuerungssoftware zur Ausführung eines entsprechenden Verfahrens kann in einem der Speicherelemente 56 bis 58 abgelegt sein.

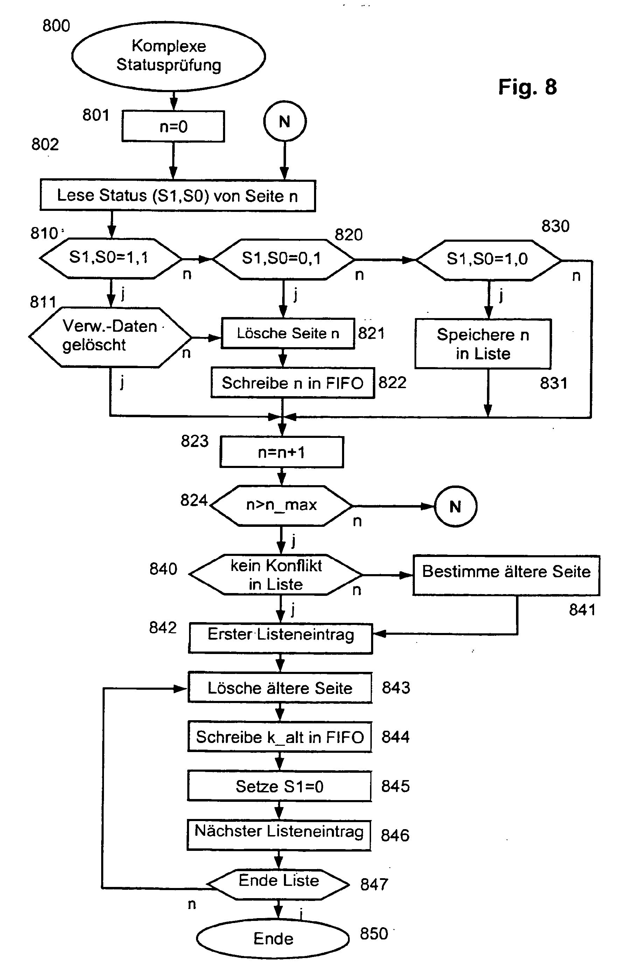

In Fig. 7 ist der Ablauf gemäß einer Ausführungsform der vorliegenden Erfindung für eine komplexe Transaktion dargestellt. Die komplexe Transaktion faßt eine Vielzahl von Schritten zusammen, in welchen jeweils Daten in Speichersegmente geschrieben werden können. Die komplexe atomare Transaktion nach Fig. 7 soll zusammen mit der Rückführung nach Fig. 8 sicherstellen, daß die von der komplexen Transaktion betroffenen Speichersegmente entweder alle geändert sind oder aber alle unverändert sind.

In einem entsprechenden Verfahren 70 bis 74 wird zunächst in einem Schritt 71 für jede betroffene Speicherseite die Abfolge der Schritte 21 bis 23 aus Fig. 2 ausgeführt. Für jede betroffene Speicherseite wird also im Laufe der komplexen Transaktion das Einlesen des Zählers der Seite i, das Einlesen eines neuen Seitenindex aus dem Ringpuffer und das Schreiben der neuen Seiten in die Seite j ausgeführt. Erst wenn die notwendigen Schritte der komplexen Transaktion an sich abgeschlossen sind, also auch alle Speicherseiten geschrieben sind, wird in einem Schritt 72 der komplexen atomaren Transaktion für jede der betroffenen Speicherseiten das Statusbit S0 auf Null gesetzt. Schließlich wird ein übergeordneter Schritt 73 mit den Teilschritten 25 bis 27 der Fig. 2 für jede betroffene Speicherseite einzeln ausgeführt. Der Schritt 73 umfaßt ein Löschen der alten Seite, ein Schreiben des alten Seitenindex in den Ringpuffer und ein Setzen des Statusbit S1 auf Null in der neuen Seite.

Das in Fig. 8 gezeigte Verfahren 800 bis 850 für eine komplexe Statusüberprüfung bzw. zur Behandlung von Unterbrechungen während einer komplexen atomaren Transaktion ist an das Verfahren nach Fig. 7 angepaßt.

Das Verfahren beginnt mit einer Schleife 801, 823, 824, in welcher für alle Speicherseiten n der Status in einem Schritt 802 ausgelesen wird. Es wird mit der nächsten Speicherseite in der Schleife fortgefahren, wenn gemäß Verzweigung 810 der Status der Speicherseite den Wert (1,1) hat und gemäß Verzweigung 811 die Verwaltungsdaten bereits gelöscht sind. Hat dagegen der Status der Speicherseite den Wert (0,1) oder aber sind die Verwaltungsdaten der Speicherseite nicht gelöscht, so wird gemäß Verzweigung 820 und 811 eine entsprechende Speicherseite in einem Schritt 821 gelöscht sowie der Seitenindex in einem Schritt 822 in den Ringpuffer geschrieben. Wenn der Status der Speicherseite (1,0) ist, wird zumindest der Index n der Speicherseite in eine Liste gespeichert 831.

Die Liste umfaßt somit für jede weiter zu behandelnde Speicherseite zumindest den Index, der vorzugsweise durch die physikalische oder die virtuelle Adresse der Speicherseite gebildet wird. Weitere bereits aus der Speicherseite ausgelesene Verwaltungsdaten, die im Laufe des Verfahrens noch verwendet werden, also insbesondere der Vorgängerverweis (k_alt) und der Altersrangzähler, können ebenfalls in der Liste abgelegt werden.

Nachdem alle Speicherseiten auf ihren Status überprüft sind, wird in einer Verzweigung 840 eine Prüfung auf Konflikte in der Liste der Speicherseiten mit dem Status (1,0) ausgeführt. Ein Konflikt liegt vor, wenn zwei Speicherseiten in der Liste sich gegenseitig als jeweilige Vorgängerseite angeben. Für einen solchen Konfliktfall wird in einem Schritt 841 die ältere Speicherseite anhand der Altersrangzähler C1 und C2 der in Konflikt stehenden Speicherseiten bestimmt.

In einer Schleife mit den Schritten 842 bis 847 werden dann die Listeneinträge einzeln abgearbeitet. Zunächst wird ein Zeiger, der auf den gerade zu bearbeitenden Listeneintrag zeigt, auf den ersten Listeneintrag gesetzt (Schritt 842). In einem Schritt 843 wird die ältere Speicherseite k_alt gelöscht und der Seitenindex k_alt in einem Schritt 844 in den Ringpuffer geschrieben. Danach wird das Statusbit S1 der neuen Speicherseite in einem Schritt 845 auf Null gesetzt. Die Schritte 843 bis 845 werden durch den Übergang zum nächsten Listeneintrag in Schritt 846 und die Verzweigung 847, in der auf das Ende der Liste geprüft wird, für alle Einträge der Liste abgearbeitet.

Die Schritte 810, 811 und 820 bis 822 sind optionale Schritte des Verfahrens. Die Indizes der durch diese Schritte behandelten Speicherseiten sind nicht mehr oder noch nicht im Ringpuffer gespeichert und werden daher auch nicht weiter verwendet. Ein Aufräumen des Datenspeichers durch Auswerten und Behandeln dieser Speicherseiten kann daher unabhängig von der Rückführung von Daten nach atomaren Transaktionen erfolgen.

Für die Verwaltung der virtuellen Adressen von Speichersegmenten kann eine Tabelle verwendet werden.

Eine solche Tabelle kann im flüchtigen oder im nichtflüchtigen Speicher gehalten werden und ordnet einer verwendeten virtuellen Adresse den Index einer Speicherseite oder dessen physikalischer Adresse zu. Alle Zugriffe auf Nutzdaten in den Speichersegmenten müssen dann über die entsprechende Tabelle erfolgen. Bei einem Einschalten eines mobilen Datenträgers mit einer entsprechenden Anzahl von Flash-Speicherseiten wird diese Tabelle im RAM erzeugt, durch Überprüfen aller Flash-Speicherseiten.

Haben beide Zustandsbits S1 und S0 einer Speicherseite i den Wert 0, dann handelt es sich um eine allokkierte Seite, die anhand ihrer virtuellen Adresse a mit einem Verweis auf die physikalische Adresse in die Tabelle eingetragen wird: *pBlock [a] = &*(*Seite i*)*.*

Wenn die Zustandsbits S1 und S0 einer Speicherseite beide gleich 1 sind, der Rest des Verwaltungswortes gelöscht ist und auch der gesamte Nutzdatenbereich gelöscht ist, dann handelt es sich um eine freie Speicherseite. Der entsprechende Seitenindex wird in einem Speicherelement bzw. in einem Ringpuffer im RAM gespeichert.

Alle anderen Zustände werden durch die zuvor beschriebenen Verfahren zur Behandlung von Unterbrechungen auf diese beiden Grundzustände zurückgeführt.

Ein solcher Mechanismus verhält sich jedoch bei Lesezugriffen auf die Speicherseiten nicht transparent, benötigt also einen höheren Verwaltungsaufwand auf einer Ebene des Speicherzugriffs und führt daher zu verlängerten Zugriffszeiten.

Der Verwaltungsaufwand durch eine Adressierungstabelle kann durch Verwendung von Speichersegmenten, wie sie in Fig. 6 gezeigt sind, vermieden werden.

In Fig. 6 sind Steuer-, Adreß- und Datenleitungen 611 bis 618 gezeigt, die mit einer Flash-Speicherseite 601 verbunden sind. Die Speicherseite 601 weist beispielsweise 1x32 Bit Verwaltungsdaten und 64x32 Bit Nutzdaten auf. Lediglich angedeutet ist, daß neben der Speicherseite 601 weitere Speicherseiten 602 in dem entsprechenden Datenspeicher angeordnet sind, die jeweils entsprechend ausgebildet sind.

Für die Speicherseite 601 sind Mittel zum Aktivieren bzw. Freigeben der Speicherseite 621 bis 626 für einen Zugriff auf die Speicherseite vorgesehen. Vor einer Beschreibung der Details der Aktivierungsmittel 621 bis 626, wird zunächst das grundsätzliche Verhalten der Speicherseite im aktivierten Zustand in Abhängigkeit von den anliegenden Signalen beschrieben.

Für das Signal einer Steuerleitung 611, das einen Lesezugriff anzeigt, und das Signal einer Steuerleitung 612, das einen Schreibzugriff anzeigt, gibt das Signal einer Steuerleitung 615 an, ob entweder auf die Nutzdaten oder die Verwaltungsdaten der Speicherseite zugegriffen werden soll. Wenn das Signal auf der Steuerleitung 611 gesetzt ist, werden die über das Signal der niedrigen Adreßleitung 617 adressierten Daten auf die Datenleitung 618 ausgegeben. Ist dagegen das Signal der Steuerleitung 612 gesetzt, wird der Wert, der sich momentan auf der Datenleitung 618 befindet in die Speicherseite geschrieben.

Ist das Signal auf einer Steuerleitung 613 gesetzt, so wird die gesamte Speicherseite 601 gelöscht, d. h. sowohl die Nutzdaten als auch die Verwaltungsdaten werden auf 0xFF gesetzt. Durch das Signal einer Steuerleitung 614 wird angegeben, ob die Adressierung einer Speicherseite über die physikalischen Adressen (direkt) oder über die virtuellen Adressen (assoziativ) der Speicherseiten erfolgt. Ein gesetztes Signal auf der Datenleitung 614 (~ass/dir) kodiert eine direkte Adressierung. Analog kodiert die "1" auf der Datenleitung 615 (~data/admin) einen Zugriff auf die Verwaltungsdaten und die "0" einen Zugriff auf die Nutzdaten der Speicherseite.

Die Speicherseite 601 ist deaktiviert, wenn das Aktivierungs-Signal gleich "0" ist. Die Signale der Steuerleitungen 611 bis 613 haben dann keine Auswirkung. Ist das Aktivierungs-Signal für die Speicherseite 601 gleich "1", dann haben die Steuersignale der Steuerleitungen 611 bis 613 die oben beschriebene Wirkung.

Die Mittel zur Aktivierung der Speicherseite 601 umfassen einen Festwertspeicher 626, in welchem die physikalische Adresse des Seitenspeichers 601 abgelegt ist. Ein Multiplexer 625 wählt entsprechend dem Steuersignal 614 entweder die physikalische Adresse 626 oder die virtuelle Adresse a des Seitenspeichers 601 aus. Die ausgewählte Adresse wird in einem Komparator 624 mit der Adresse auf einer Adress-Leitung 616 verglichen.

Wird durch die Adress-Leitung 616 die Speicherseite 601 referenziert, so wird durch ein UND-Gatter 621, ein ODER-Gatter 622 und ein NOR-Gatter 623 bestimmt, ob die Speicherseite für ein Löschen, Lesen oder Schreiben gemäß einem der Steuersignale 611 bis 613 freigegeben bzw. aktiviert ist. Die Speicherseite ist freigegeben für den Zugriff über das ODER-Gatter 622, wenn das Steuersignal 614 eine direkte Adressierung über eine physikalische Adresse anzeigt. Ebenfalls freigegeben ist die Speicherseite, wenn ein Status S1, S0 mit dem Wert (0,0), der über das NOR-Gatter 623 ausgewertet wird, vorliegt.

Aktivierungsmittel werden zumindest für jede Speicherseite vorgesehen, die über einen entsprechenden Status verwaltet und virtuell adressierbar sein soll.

Im Folgenden werden einzelne Aspekte der beschriebenen Ausführungsformen angesprochen, um zu verdeutlichen wie diese Ausführungsformen weiter abgewandelt werden können.

Die mit Bezug auf die Figuren beschriebenen Ausführungsformen sind angepaßt für eine Flash-Speicherseite, die ein schnelles Schreiben von einem Wert "1" auf einen Wert "0" ermöglicht und ein dagegen langsameres Löschen vom Wert "0" auf den Wert "1" benötigt. Die angegebenen Lösungen sind jedoch ohne weiteres auch auf einen Speicher mit dazu inversem Verhalten (schnelles Schreiben von "0" auf "1" und langsames Löschen von "1" auf "0") übertragbar.

Zur Veranschaulichung der Zugriffszeiten wird von 60 µs für einen Schreibzugriff und 8000 µs für das Löschen einer Speicherseite ausgegangen. Nach dem zumindest internen Stand der Technik erfolgt ein atomarer Schreibvorgang unter Verwendung eines Rückführpuffers durch Sichern der alten Daten für eine Seite mit 64*32 Bits Nutzdaten (64*60 µs), Löschen der Seite (8000 µs), Schreiben der neuen Daten (64*60 µs) und Löschen des Rückführpuffers (8000 µs) in insgesamt 23680 µs.

Durch das Vorgehen nach Fig. 2 kann die Dauer eines atomaren Schreibvorganges nahezu halbiert werden. Nach einem Schreiben der neuen Daten ((64+1)*60µs), Löschen des Zustandsbits S0 (60 µs), Löschen der alten Seite (8000 µs) und Löschen des Zustandsbits S1 (60 µs) liegt die Gesamtdauer bei 12020 µs.

Zwar erzielen die erfindungsgemäßen Lösungen einen größeren Nutzen bei Speichern wie beispielsweise Flash-EEPROM, die eine lange Löschzeit aufweisen, jedoch können sie ebenso auf EEPROM, S-RAM oder andere nichtflüchtige Datenspeicher angewendet werden.

In den Verfahren nach Fig. 4, 7 und 8 müssen die Schritte die alle Speicherseiten betreffen sollen (siehe beispielsweise Lesen 401, Suchen 431) nur für die Speicherseiten ausgeführt werden, die für ein entsprechendes Verfahren vorgesehen sind. Ein Datenspeicher kann also einen erste Gruppe von Speicherseiten aufweisen, die für ein abgesichertes Schreiben vorgesehen ist, und eine zweiten Gruppe von Speicherseiten, die nicht für atomare Schreibvorgänge vorgesehen ist. In einem solchen Datenspeicher könnten beispielsweise nur die Speicherseiten der ersten Gruppe mit Aktivierungsmitteln nach Fig. 6 ausgestattet sein.

Es ist zwar vorteilhaft eine virtuelle Adresse in den Verwaltungsdaten einer Speicherseite zu speichern, jedoch nicht notwendig. Die beschriebenen Verfahren und Vorrichtungen können auch unabhängig von einer virtuellen Adressierung oder einer konkreten Form der Verwaltung einer virtuellen Adresse eingesetzt werden.

In tragbaren Datenträgern ohne eigene Stromversorgung wird vorzugsweise ein Löschen der Speicherseiten wie beschrieben ausgeführt. Beispielsweise um die Bearbeitungszeit einer komplexen Transaktion zu reduzieren, können die Schritte des Löschen einer Speicherseite zunächst ausgelassen werden. Die betroffenen Speicherseiten müssen dann, anstatt gelöscht zu werden, mit einem Status "zu Löschen" versehen werden. Dazu wird das Statusdatenelement um ein entsprechendes Bit erweitert, das im geschriebenen Zustand diesen Status signalisiert. Zu einem geeigneten späteren Zeitpunkt werden die zu löschenden Speicherseiten dann gelöscht.

## Patentansprüche

1. Verfahren zur Absicherung von Daten in einem nichtflüchtigen und in Speichersegmente unterteilten Datenspeicher eines tragbaren Datenträgers, wobei die Daten in den Speichersegmenten Verwaltungsdaten für die jeweiligen Speichersegmente umfassen, mit folgenden Schritten in dem tragbaren Datenträger:
Schreiben (23) von neuen Daten in ein erstes Speichersegment des Datenspeichers, welche alte Daten in einem zweiten Speichersegment des Datenspeichers ersetzen sollen;
Löschen (25) des zweiten Speichersegments;
Ändern (24, 27) eines Statusdatenelements (13) in den Verwaltungsdaten des ersten oder des zweiten Speichersegments, um die neuen Daten in dem ersten Speichersegment als zu verwendende gespeicherte Daten zu kennzeichnen,
wobei die Verwaltungsdaten der Speichersegmente jeweils einen Vorgängerverweis (15) auf das zuvor adressierte Speichersegment enthalten;
**dadurch gekennzeichnet, dass**
dass die Verwaltungsdaten der Speichersegmente jeweils Altersrangdaten (14) als weiteres Datenelement enthalten, welches für den Fall, dass der Schritt des Löschen (25) nicht vollständig ausgeführt wird, die Bestimmung des Altersranges der Daten in dem zweiten Speichersegment gegenüber den Daten in dem ersten Speichersegment auch in dem Fall ermöglicht, dass beide Vorgängerverweise gegenseitig aufeinander verweiten; und
dass die Altersrangdaten (14) zumindest drei Zustände kodieren können und sich in nur einem Bit von einem gelöschten Zustand unterscheiden.

2. Verfahren gemäß Anspruch 1, **dadurch gekennzeichnet, dass**
der Schritt des Änderns (24,27) des Statusdatenelements (13) umfaßt:
Erstes Ändern (24) des Statusdatenelements (13), um anzugeben dass das erste Speichersegment vollständig geschrieben wurde und
Zweites Ändern (27) des Statusdatenelements (13), um anzugeben dass das zweite Speichersegment vollständig gelöscht wurde.

3. Verfahren gemäß einem der Ansprüche 1 bis 2, **dadurch gekennzeichnet, dass** für den Schritt des Schreibens (23) die Altersrangdaten (14) des ersten Speichersegments abhängig von den Altersrangdaten des zweiten Speichersegments bestimmt werden.

4. Verfahren gemäß einem der Ansprüche 2 bis 3, **dadurch gekennzeichnet, dass** zur Absicherung eines Vorgangs mit einer Vielzahl zu ersetzender Daten die folgenden Schritte jeweils für alle der zu ersetzenden Daten abgeschlossen werden, bevor mit dem Nächsten der Schritte fortgefahren wird:
der Schritt des Schreibens (23) der neuen Daten;
der Schritt des ersten Änderns (24) des Statusdatenelements (13); und
ein Schritt umfassend das Löschen (25) der alten Daten und das zweite Ändern (24) des Statusdatenelements (13).

5. Verfahren zur Absicherung von Daten in einem nichtflüchtigen und in Speichersegmente unterteilten Datenspeicher eines tragbaren Datenträgers, wobei die Daten in den Speichersegmenten Verwaltungsdaten für die jeweiligen Speichersegmente umfassen, mit den Schritten in dem tragbaren Datenträger:
Lesen (401; 802) von Verwaltungsdaten eines ersten Speichersegments, welche ein Statusdatenelement und einen Verweis auf ein Vorgänger-Speichersegment des ersten Speichersegmentes enthalten;
Auswerten der gelesenen Verwaltungsdaten, wobei das Statusdatenelement des ersten Speichersegments verwendet wird (402; 810), das in den gelesenen Verwaltungsdaten enthalten ist; und
Löschen (424, 432; 821) eines Speichersegments abhängig von dem Ergebnis des Schrittes des Auswertens;
**dadurch gekennzeichnet, dass**
in dem Schritt des Auswertens als weiteres Datenelement der Verwaltungsdaten des ersten Speichersegments Altersrangdaten verwendet werden (422; 841), um den Altersrang der Daten des ersten Speichersegments gegenüber Daten eines zweiten Speichersegments zu bestimmen, so dass die Bestimmung auch in dem Fall dass beide Vorgängerverweise gegenseitig aufeinander verweiten möglich ist; und
in dem Schritt des Löschens (424; 843) abhängig von dem Ergebnis des Schrittes des Auswertens das erste oder das zweite Speichersegment gelöscht wird und
dass die Altersrangdaten (14) zumindest drei Zustände kodieren können und dass die Altersrangdaten (14) sich in nur einem Bit von einem gelöschten Zustand unterscheiden.

6. Verfahren gemäß Anspruch 5, **dadurch gekennzeichnet, dass** der Schritt des Auswertens (402, 810) des Statusdatenelements für die Speichersegmente des Datenspeichers ausgeführt wird, um den Schritt des Auswertens (411, 422; 840) und das Löschen (824; 843) des ersten oder des zweiten Speichersegments abhängig von einer Anzahl der Speichersegmente mit einem Statusdatenelement , das ein unvollständiges Löschen eines alten Speichersegments anzeigt, auszuführen.

7. Verfahren gemäß einem der Ansprüche 5 bis 6, **dadurch gekennzeichnet, dass** in dem Fall, dass zwei Statusdatenelemente ein unvollständiges Löschen anzeigen, die Altersrangdaten (14) für die Bestimmung der älteren Seite verwendet werden.

8. Verfahren gemäß einem der Ansprüche 5 bis 7, **dadurch gekennzeichnet dass** in dem Fall, dass nur ein Statusdatenelement ein unvollständiges Löschen anzeigt, der Verweis (15) für die Bestimmung der älteren Seite verwendet wird.

9. Verfahren gemäß einem der Ansprüche 5 bis 8, **gekennzeichnet durch** die Schritte des Verfahrens gemäß Anspruch 1.

10. Tragbarer Datenträger mit einer Datenstruktur zur Verwaltung von Daten in einem nichtflüchtigen und in Speichersegmente unterteilten Datenspeicher, wobei die Datenstruktur in den Speichersegmenten (10) Verwaltungsdaten (11) und Nutzdaten (12) enthält, die Verwaltungsdaten (11) zur Kennzeichnung eines Zustandes des jeweiligen Speichersegments Statusdaten (13) umfassen und die Verwaltungsdaten einen Vorgängerverweis (14) umfassen, **dadurch gekennzeichnet, dass** die Verwaltungsdaten weiterhin Altersrangdaten (15) umfassen, welche, wenn die Statusdaten (13) eines ersten Speichersegments (i) eine nicht vollständige Löschung eines zweiten Speicher segments (j) anzeigen, eine Bestimmung des relativen Altersranges der Daten in dem zweiten Speichersegment (j) gegenüber den Daten in dem ersten Speichersegment (i) auch in dem Fall ermöglichen, dass beide Vorgängerverweise gegenseitig aufeinander verweiten, und **dadurch** dass die Altersrangdaten (14) zumindest drei Zustände kodieren können und sich in nur einem Bit von einem gelöschten Zustand unterscheiden.

11. Tragbarer Datenträger umfassend Mittel angepaßt zur Ausführung eines Verfahrens nach einem der Ansprüche 1 bis 9.

12. Mobiles Kommunikationsgerät umfassend einen tragbaren Datenträger gemäß Anspruch 11.

13. Mobiles Kommunikationssystem umfassend ein mobiles Kommunikationsgerät nach Anspruch 12.

14. System zur Ausführung einer gesicherten Transaktion, umfassend eine Vielzahl tragbarer Datenträger nach Anspruch 10, die personenbezogene Daten enthalten, und zumindest einer Einheit mit Mitteln zur Kommunikation mit einem der Datenträger.

## Claims

1. A method for securing data in a non-volatile data memory of a portable data carrier, said memory being divided into memory segments, and the data in the memory segments comprising management data for the particular memory segments, having the following steps in the portable data carrier:
writing (23) new data to a first memory segment of the data memory which are to replace old data in a second memory segment of the data memory;
deleting (25) the second memory segment;
changing (24, 27) a status data element (13) in the management data of the first or second memory segment to identify the new data in the first memory segment as stored data to be used, the management data of the memory segments in each case containing a predecessor reference (15) to the previously addressed memory segment;
**characterized in that**
the management data of the memory segments in each case contain age rank data (14) as a further data element which, in the event that the deleting step (25) is incompletely executed, permits determination of the age rank of the data in the second memory segment relative to the data in the first memory segment even in the event that the two predecessor references refer mutually to each other; and the age rank data (14) can encode at least three states and differ from a deleted state in only one bit.

2. The method according to claim 1, **characterized in that**
the step of changing (24, 27) the status data element (13) comprises:
first changing (24) of the status data element (13) to specify that the first memory segment has been completely written, and
second changing (27) of the status data element (13) to specify that the second memory segment has been completely deleted.

3. The method according to either of claims 1 to 2, **characterized in that** for the writing step (23) the age rank data (14) of the first memory segment are determined in dependence on the age rank data of the second memory segment.

4. The method according to either of claims 2 to 3, **characterized in that** for securing a process with a multiplicity of data to be replaced, the following steps are completed in each case for all of the data to be replaced before continuing with the next one of the steps:
the step of writing (23) the new data;
the step of first changing (24) of the status data element (13); and
a step comprising the deletion (25) of the old data and the second changing (24) of the status data element (13).

5. A method for securing data in a non-volatile data memory of a portable data carrier, said memory being divided into memory segments, and the data in the memory segments comprising management data for the particular memory segments, having the steps in the portable data carrier:
reading (401; 802) management data of a first memory segment which contain a status data element and a reference to a predecessor memory segment of the first memory segment,
evaluating the read management data, using the status data element of the first memory segment (402; 810) which is contained in the read management data; and
deleting (424, 432; 821) a memory segment in dependence on the result of the evaluating step;
**characterized in that**
in the evaluating step, age rank data are used (422; 841) as a further data element of the management data of the first memory segment in order to determine the age rank of the data of the first memory segment relative to data of a second memory segment, so that the determination is also possible in the event that the two predecessor references refer mutually to each other; and
in the deleting step (424; 843) the first or the second memory segment is deleted in dependence on the result of the evaluating step, and
the age rank data (14) can encode at least three states, and that the age rank data (14) differ from a deleted state in only one bit.

6. The method according to claim 5, **characterized in that** the step of evaluating (402, 810) the status data element is executed for the memory segments of the data memory in order to execute the evaluating step (411, 422; 840) and the deletion (824; 843) of the first or second memory segment in dependence on a number of memory segments with a status data element indicating an incomplete deletion of an old memory segment.

7. The method according to either of claims 5 to 6, **characterized in that** in the event that two status data elements indicate an incomplete deletion, the age rank data (14) are used for determining the older page.

8. The method according to any of claims 5 to 7, **characterized in that** in the event that only one status data element indicates an incomplete deletion, the reference (15) is used for determining the older page.

9. The method according to any of claims 5 to 8, **characterized by** the steps of the method according to claim 1.

10. A portable data carrier with a data structure for managing data in a non-volatile data memory divided into memory segments, the data structure containing management data (11) and user-defined data (12) in the memory segments (10), the management data (11) comprising status data (13) for identifying a state of the particular memory segment, and the management data comprising a predecessor reference (14), **characterized in that**
the management data further comprise age rank data (15) which, when the status data (13) of a first memory segment (i) indicate an incomplete deletion of a second memory segment (j), permit a determination of the relative age rank of the data in the second memory segment (j) relative to the data in the first memory segment (i) even in the event that the two predecessor references refer mutually to each other, and the age rank data (14) can encode at least three states and differ from a deleted state in only one bit.

11. A portable data carrier comprising means adapted for executing a method according to any of claims 1 to 9.

12. A mobile communication device comprising a portable data carrier according to claim 11.

13. A mobile communication system comprising a mobile communication device according to claim 12.

14. A system for performing a secure transaction, comprising a multiplicity of portable data carriers according to claim 10 which contain personal data, and at least one unit with means for communication with one of the data carriers.

## Revendications

1. Procédé de protection de données dans une mémoire de données non volatile subdivisée en segments de mémoire d'un support de données portable, les données comprenant dans les segments de mémoire des données administratives pour les segments de mémoire respectifs, avec les étapes suivantes dans le support de données portable :
écriture (23), dans un premier segment de mémoire de la mémoire de données, de nouvelles données qui doivent remplacer des anciennes données dans un deuxième segment de mémoire de la mémoire de données ;
effacement (25) du deuxième segment de mémoire ;
modification (24, 27) d'un élément de données de statut (13) dans les données administratives du premier ou du deuxième segment de mémoire afin de marquer les nouvelles données dans le premier segment de mémoire en tant que données mémorisées devant être utilisées,
les données administratives des segments de mémoire contenant respectivement un renvoi (15) au prédécesseur, au segment de mémoire dans lequel des données furent précédemment adressées ;
**caractérisé en ce que**
les données administratives des segments de mémoire comportent respectivement des données de rang d'ancienneté (14) en tant qu'élément de données supplémentaire qui, dans le cas où l'étape de l'effacement (25) n'est pas complètement accomplie, rend possible la détermination du rang d'ancienneté des données se trouvant dans le deuxième segment de mémoire par rapport aux données se trouvant dans le premier segment de mémoire aussi dans le cas où les renvois aux prédécesseurs renvoient tous les deux réciproquement l'un à l'autre ; et
**en ce que** les données de rang d'ancienneté (14) peuvent coder au moins trois états et se distinguent en seulement un bit d'un état effacé.

2. Procédé selon la revendication 1, **caractérisé en ce que** l'étape de la modification (24, 27) de l'élément de données de statut (13) comprend :
Première modification (24) de l'élément de données de statut (13) afin d'indiquer que le premier segment de mémoire a été complètement écrit et
Deuxième modification (27) de l'élément de données de statut (13) afin d'indiquer que le deuxième segment de mémoire a été complètement effacé.

3. Procédé selon une des revendications de 1 à 2, **caractérisé en ce que,** pour l'étape de l'écriture (23), les données de rang d'ancienneté (14) du premier segment de mémoire sont déterminées en fonction des données de rang d'ancienneté du deuxième segment de mémoire.

4. Procédé selon une des revendications de 2 à 3, **caractérisé en ce que,** pour la protection d'une opération comprenant un grand nombre de données à remplacer, les étapes suivantes sont, avant de passer ensuite à la prochaine étape, respectivement accomplies pour toutes les données à remplacer:
l'étape de l'écriture (23) des nouvelles données ;
l'étape de la première modification (24) de l'élément de données de statut (13); et une étape comprenant l'effacement (25) des anciennes données et la deuxième modification (24) de l'élément de données de statut (13).

5. Procédé de protection de données dans une mémoire de données non volatile subdivisée en segments de mémoire d'un support de données portable, les données comprenant dans les segments de mémoire des données administratives pour les segments de mémoire respectifs, avec les étapes dans le support de données portable :
Lecture (401, 802) de données administratives d'un premier segment de mémoire qui contiennent un élément de données de statut et un renvoi à un segment de mémoire prédécesseur du premier segment de mémoire ;
Dépouillement des données administratives lues, l'élément de données de statut contenu dans les données administratives lues du premier segment de mémoire étant utilisé (402, 810) ; et
Effacement (424, 432, 821) d'un segment de mémoire en fonction du résultat de l'étape du dépouillement ;
**caractérisé en ce que,**
lors de l'étape du dépouillement, des données de rang d'ancienneté sont utilisées en tant qu'élément de données supplémentaire des données administratives du premier segment de mémoire (422, 841) afin de déterminer le rang d'ancienneté des données du premier segment de mémoire par rapport à des données d'un deuxième segment de mémoire, de telle sorte que la détermination est possible aussi dans le cas où les renvois aux prédécesseurs renvoient tous les deux réciproquement l'un à l'autre ; et
**en ce que** lors de l'étape de l'effacement (424, 843), le premier ou le deuxième segment de mémoire est effacé en fonction du résultat de l'étape du dépouillement et
**en ce que** les données de rang d'ancienneté (14) peuvent coder au moins trois états et **en ce que** les données de rang d'ancienneté (14) se distinguent en seulement un bit d'un état effacé.

6. Procédé selon la revendication 5, **caractérisé en ce que** l'étape du dépouillement (402, 810) de l'élément de données de statut est effectuée pour les segments de mémoire de la mémoire de données afin d'effectuer l'étape du dépouillement (411, 422, 840) et l'effacement (824, 843) du premier ou du deuxième segment de mémoire en fonction d'un nombre des segments de mémoire ayant un élément de données de statut indiquant un effacement incomplet d'un ancien segment de mémoire.

7. Procédé selon une des revendications de 5 à 6, **caractérisé en ce que,** dans le cas où deux éléments de données de statut indiquent un effacement incomplet, les données de rang d'ancienneté (14) sont utilisées pour la détermination de la page la plus ancienne.

8. Procédé selon une des revendications de 5 à 7, **caractérisé en ce que,** dans le cas où seulement un élément de données de statut indique un effacement incomplet, le renvoi (15) est utilisé pour la détermination de la page la plus ancienne.

9. Procédé selon une des revendications de 5 à 8, **caractérisé par** les étapes du procédé selon la revendication 1.

10. Support de données portable comportant une structure de données pour l'administration de données dans une mémoire de données non volatile subdivisée en segments de mémoire, la structure de données contenant des données administratives (11) et des données utiles (12) dans les segments de mémoire (10), les données administratives (11) comprenant des données de statut (13) pour le marquage d'un état du segment de mémoire respectif, et les données administratives comprenant un renvoi au prédécesseur (14), **caractérisé en ce que** les données administratives comprennent en outre des données de rang d'ancienneté (15) qui, quand les données de statut (13) d'un premier segment de mémoire (i) indiquent un effacement non complet d'un deuxième segment de mémoire (j), rendent possible une détermination du rang d'ancienneté relatif des données se trouvant dans le deuxième segment de mémoire (j) par rapport aux données se trouvant dans le premier segment de mémoire (i), aussi dans le cas où les renvois aux prédécesseurs renvoient tous les deux réciproquement l'un à l'autre, et **en ce que** les données de rang d'ancienneté (14) peuvent coder au moins trois états et se distinguent en seulement un bit d'un état effacé.

11. Support de données portable comprenant des moyens adaptés à la réalisation d'un procédé selon une des revendications de 1 à 9.

12. Appareil de communication mobile comprenant un support de données portable selon la revendication 11.

13. Système de communication mobile comprenant un appareil de communication mobile selon la revendication 12.

14. Système de réalisation d'une transaction protégée, comprenant un grand nombre de supports de données portables selon la revendication 10 qui contiennent des données relatives à des personnes, et au moins une unité dotée de moyens de communication avec un des supports de données.
